# EUROPÄISCHE PATENTANMELDUNG

(11) **EP 0 818 885 A2**
(43) Veröffentlichungstag der Anmeldung: **14.01.1998**
(21) Anmeldenummer: 97110152.2
(22) Anmeldetag: 20.06.1997
(51) Int. Cl.: H03H 11/12

(54) **Filterschaltung**

(30) Priorität: 12.07.1996 DE 19628255
(71) Anmelder: SIEMENS AKTIENGESELLSCHAFT, 80333 München (DE)
(72) Erfinder: Weber, Stephan, 81739 München (DE); Thomas, Volker, 81245 München (DE)

(57) **Zusammenfassung**

Filterschaltung mit einem in integrierter Schaltungstechnik ausgeführten, hochohmige Widerstandselemente (6, 8) und kleinere Kapazitäten (7, 9) aufweisenden, ersten Teilfilter (6 bis 10) und
mit einem diesen vorgeschalteten, diskret aufgebauten, niederohmige Widerstandselemente (2, 4) und größere Kapazitäten (3, 5) aufweisenden, zweiten Teilfilter (2 bis 5).

## Beschreibung

Die Erfindung betrifft eine Filterschaltung.

In Verbindung mit integrierten Schaltkreisen werden häufig Filterschaltungen höherer Ordnung benötigt, die -wie beispielsweise aus U.Tietze, Ch.Schenk, Electronic Circuits-Design and Applications, Berlin, Heidelberg 1991, S. 376-379 bekannt ist- durch Kaskadieren mehrerer Teilfilter erster oder zweiter Ordnung realisiert werden. Die Teilfilter sind dabei jeweils für sich als aktive Filter ausgelegt. An das Filter sind in der Regel bestimmte relativ strenge Toleranzanforderungen zu stellen, die mit Standard-Integrationstechniken nicht erreichbar sind. Hinzu kommt bei niedrigen Grenzfrequenzen, daß verhältnismäßig viel Chipfläche bedingt durch die großen Kapazitäten und Widerstände benötigt wird. Die Verwendung extrem hochohmiger Widerstände hat seinerseits neben meist großen Toleranzen auch den Nachteil, daß sich stets vorhandene Biasströme wesentlich stärker als unerwünschte Offset-Spannungen bemerkbar machen. Beispielsweise bei der Realisierung von präzisen Filtern mit großen Zeitkonstanten wurde daher bisher auf externe Widerstände und Kapazitäten in Verbindung mit integrierten Verstärkern zurückgegriffen. Bei Filtern höherer Ordnung erfordert dies jedoch viele Anschlußpins und die Offset-Spannungen der einzelnen Verstärker summieren sich entsprechend.

Aufgabe der Erfindung ist es, eine demgegenüber verbesserte Filterschaltung anzugeben.

Die Aufgabe wird durch eine Filterschaltung gemäß Patentanspruch 1 gelöst. Die erfindungsgemäße Filterschaltung umfaßt dazu ein in integrierter Schaltungstechnik ausgeführtes, hochohmige Widerstandselemente und kleinere Kapazitäten aufweisendes, erstes Teilfilter sowie ein diesem vorgeschaltetes, diskret ausgebautes, niederohmige Widerstandselemente und größere Kapazitäten aufweisendes, zweites Teilfilter.

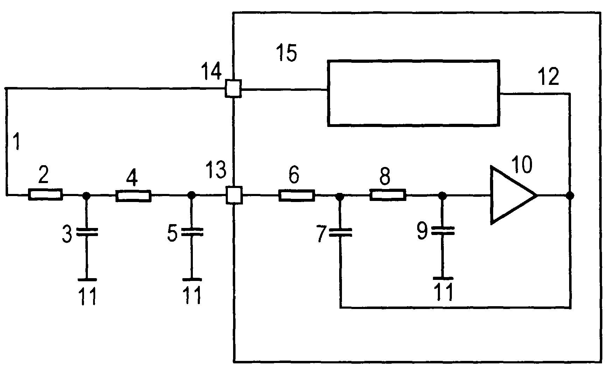

Die Erfindung wird nachfolgend anhand des in der einzigen Figur der Zeichnung dargestellten Ausführungsbeispiels näher erläutert.

Bei dem als Ausführungsbeispiel gezeigten Filter handelt es sich um ein Tiefpaßfilter vierter Ordnung mit sehr niedriger Grenzfrequenz beispielsweise zum Ausfiltern von Gleichanteilen in einem Eingangssignal 1. Das Filter besteht aus zwei Teilfiltern 2 bis 5 und 6 bis 10, von denen das Filter 6 bis 10 vollständig in integrierter Technik ausgeführt ist und das Filter 2 bis 5 mit diskreten Bauelementen außerhalb der integrierten Schaltung aufgebaut ist.

Im einzelnen handelt es sich bei dem Teilfilter 6 bis 10 um ein aktives Tiefpaßfilter zweiter Ordnung mit einfach positiver Rückkopplung. Einem Verstärker 10 ist dabei eingangsseitig eine Kapazität 9 parallel geschaltet, indem diese zwischen den Eingang des Verstärkers 10 und ein Bezugspotential 11 geschaltet ist. Der Eingang des Verstärkers 10 ist zudem über einen Widerstand 8 an einen Knotenpunkt geführt, der zum einen über einen Kondensator 7 mit dem ein Ausgangssignal 12 führenden Ausgang des Verstärkers 10 und zum anderen über einen Widerstand 6 mit einem Anschlußpin 13 gekoppelt.

Extern ist der Anschlußpin 13 über einen Kondensator 5 mit dem Bezugspotential 11 und über einen Widerstand 4 mit einem Knotenpunkt gekoppelt ist, der seinerseits über einen Kondensator 3 mit dem Bezugspotential 11 und über einen Widerstand 2 mit einem das Eingangssignal 1 führenden Anschlußpin 14 verbunden ist. Das Teilfilter 2 bis 5 ist somit durch zwei hintereinander geschaltete Tiefpaßfilter erster Ordnung gegeben, wobei der Widerstand 2 wesentlich niederohmiger ausgeführt ist als der Widerstand 4 und dementsprechend die Kapazität des Kondensators 3 wesentlich größer ist als die Kapazität des Kondensators 5.

Gegenüber dem Widerstand 4 sind wiederum die Widerstände 6 und 8 erheblich hochohmiger und in gleicher Weise sind die Kapazitäten der Kondensatoren 7 und 9 erheblich geringer als die Kapazität des Kondensators 5. Eine Abstufung der Widerstände 2, 4, 6, 8 ist beispielsweise derart, daß sich der Wert des Widerstandes 2 zum Wert des Widerstandes 4 wie 1:10 und der Wert der Widerstände 6 und 8 zum Wert des Widerstandes 4 ebenfalls wie 1:10 verhält.

Bei den Signalen 1 und 12 schließlich handelt es sich um interne Signale des das Teilfilter 6 bis 10 enthaltenden Schaltkreises 15. Das Signal 1 wird dabei von weiteren Schaltungsteilen des Schaltkreises 15 bereitgestellt und das Signal 12 an diese weiteren Schaltungsteile wiederum weitergeleitet.

Die erfindungsgemäße Filterschaltung verknüpft die Vorteile eines externen Filters wie beispielsweise enge Toleranzen und problemlose Realisierung großer Zeitkonstanten mit denen eines integrierten Filters wie geringer Platzbedarf und wenig Anschlußpins. Außerdem wird durch die besondere Kombination der externen und der integrierten Elemente die Offset-Spannung sowohl gegenüber der rein externen als auch der rein integrierten Realisierung minimiert. Dies wird insbesondere dadurch erreicht, daß die niederohmigen externen Elemente geringe Offset-Spannungen aufgrund von Biasströmen erzeugen. Des weiteren werden durch die Verwendung nur eines einzigen Verstärkerelements aktiv erzeugte Offset-Spannungen gering gehalten. Die integrierten Widerstände sind dagegen hochohmig, was sowohl Chipfläche spart, als auch das externe Teilfilter weniger belastet. Die geringe Belastung des externen Teilfilters ist deshalb günstig, da die Güte des externen Teilfilters weitestgehend erhalten bleibt.

Schließlich erfordert die passive Ausgestaltung des externen Filters nur eine geringe Anzahl weiterer Anschlußpins, die beim vorliegenden Ausführungsbeispiel lediglich gleich 2 ist.

## Patentansprüche

1. Filterschaltung mit einem in integrierter Schaltungstechnik ausgeführten, hochohmige Widerstandselemente (6, 8) und kleinere Kapazitäten (7, 9) aufweisenden, ersten Teilfilter (6 bis 10) und
mit einem diesen vorgeschalteten, diskret aufgebauten, niederohmige Widerstandselemente (2, 4) und größere Kapazitäten (3, 5) aufweisenden, zweiten Teilfilter (2 bis 5).
